# EUROPEAN PATENT APPLICATION

(11) **EP 4 741 857 A1**
(43) Date of publication of application: **13.05.2026**
(21) Application number: 24212214.1
(22) Date of filing: 11.11.2024
(51) Int. Cl.: G01R 31/54, G01R 31/58, G01R 31/66

(54) **METHOD OF DETERMINING A FUNCTIONALITY STATE OF AN ELECTRIC CONNECTION**

(71) Applicant: Janitza electronics GmbH, 35633 Lahnau (DE)
(72) Inventor: Weiß, Lukas, 35708 Haiger (DE); HAMEL, Torben, 35396 Gießen (DE)
(74) Representative: Fuchs Patentanwälte Partnerschaft mbB

(57) **Abstract**

A method (200) of determining a functionality state of an electric power supply to one or more of a plurality of electric conductors (C1 - C6) in an electric circuitry (E) comprises receiving (205), by means of a control unit (110) of an electric monitoring system (100), at least one peripheral voltage signal from at least one peripheral voltage sensor (122-1 - 122-6), the at least one peripheral voltage signal indicative of a voltage in an electric conductor (C1 - C6) of a plurality of electric conductors of an electric circuitry (E). The method (200) further comprises receiving (210), by means of the control unit (110), a supply voltage signal from at least one supply voltage sensor (116-1 - 116-3), the supply voltage signal indicative of a voltage of a supply line (S) which the electric conductor (C1 - C6) is configured to be connected to in the electric circuitry (E); determining (220), by means of the control unit (110) and based on the received peripheral voltage signal and the received supply voltage signal, a voltage amount difference (ΔA) between a voltage amount of the voltage in the electric conductor (C1 - C6) and a voltage amount of the voltage of the supply line (S); comparing (225), by means of the control unit (110), the voltage amount difference (ΔA) with a threshold voltage amount difference (T1); and, when the comparing (225) of the voltage amount difference (ΔA) with the threshold voltage amount difference (T1) yields that the voltage amount difference (ΔA) exceeds the threshold voltage amount difference (T1), determining (230), by means of the control unit (110), that an electric connection between the electric conductor (C1 - C6) and the supply line (S) is in a dysfunctional state. The method (200) further comprises, when the comparing (225) of the voltage amount difference (ΔA) with the threshold voltage amount difference (T1) yields that the voltage amount difference (ΔA) does not exceed the threshold voltage amount difference (T1): determining (235), by means of the control unit (110) and based on the received peripheral voltage signal and the received supply voltage signal, a phase angle difference (ΔP) between a phase angle of the voltage in the electric conductor (C1 - C6) and a phase angle of the voltage of the supply line (S); comparing (240), by means of the control unit (110), the phase angle difference (ΔP) with a threshold phase angle difference (T2), and, when the comparing (240) of the phase angle difference (ΔP) with the threshold phase angle difference (T2) yields that the phase angle difference (ΔP) does not exceed the threshold phase angle difference (T2), determining (245), by means of the control unit (110), that an electric connection between the electric conductor (C1 - C6) and the supply line (S) is in a functional state.

## Description

The disclosure relates to a method of determining a functionality state of an electric connection between one or more of a plurality of electric conductors and a power supply in an electric circuitry. The disclosure further relates to a computer program product, a control unit, and an electric monitoring system.

### Background

Electric monitoring is vital for the secure operation of many, especially large-scale and/or complex, electric systems, such as electric networks. Moreover, in network server plants, but also in other complex electric systems, a plurality of electric appliances, for example, a plurality of server blades, is normally powered via a shared supply line, whereas a power demand of each appliance varies frequently, and a secure operation of each appliance depends sensitively on a stable provision of an electric power via the supply line. In such scenarios, but also in many others, reliable and precise monitoring of an electric power circuitry is vital to maintaining a secure operation of the electric system.

Suitable electric monitoring facilitates, for example, an early detection of functionality states in the monitored electric system. This can include anomalies in electric parameters, which can be caused by false wiring, tripping of a power switch, excessive system load, 'worn-down' electric components or appliances, etc. Detecting one or more functionality states of the electric system, or of individual portions or components thereof, enables in some cases that one or more compensation and/or protection functionalities of the electric system are automatically initiated. Alternatively, in some cases, a signal indicative of the functionality state is output towards an operator of the electric system. The output signal enables the operator to take a decision, for example, about manual maintenance actions, or to identify a need to modify or adapt the electric system according to changing operational conditions, etc., based on the indicated functionality state(s).

There is a continuing demand for improved monitoring of electric power circuitry.

### Summary of the Disclosure

Accordingly, there is provided a method according to claim 1, a computer program product according to claim 10, a control unit according to claim 11, and an electric monitoring system according to claim 12.

According to an aspect, a method of determining a functionality state of an electric connection between one or more of a plurality of electric conductors and a power supply in an electric circuitry is provided. The method comprises receiving, by means of a control unit of an electric monitoring system, at least one peripheral voltage signal from at least one peripheral voltage sensor, the at least one peripheral voltage signal indicative of a voltage in an electric conductor of a plurality of electric conductors of an electric circuitry. The method further comprises receiving, by means of the control unit, a supply voltage signal from at least one supply voltage sensor, the supply voltage signal indicative of a voltage of a supply line which the electric conductor is configured to be connected to in the electric circuitry; determining, by means of the control unit and based on the received peripheral voltage signal and the received supply voltage signal, a voltage amount difference between a voltage amount of the voltage in the electric conductor and a voltage amount of the voltage of the supply line; and, comparing, by means of the control unit, the voltage amount difference with a threshold voltage amount difference. The method further comprises, when the comparing of the voltage amount difference with the threshold voltage amount difference yields that the voltage amount difference exceeds the threshold voltage amount difference, determining, by means of the control unit, that an electric connection between the electric conductor and the supply line is in a dysfunctional state. The method further comprises, when the comparing of the voltage amount difference with the threshold voltage amount difference yields that the voltage amount difference does not exceed the threshold voltage amount difference: determining, by means of the control unit and based on the received peripheral voltage signal and the received supply voltage signal, a phase angle difference between a phase angle of the voltage in the electric conductor and a phase angle of the voltage of the supply line, comparing, by means of the control unit, the phase angle difference with a threshold phase angle difference, and, when the comparing of the phase angle difference with the threshold phase angle difference yields that the phase angle difference does not exceed the threshold phase angle difference, determining, by means of the control unit, that an electric connection between the electric conductor and the supply line is in a functional state.

By determining that an electric connection between the electric conductor and the supply line is in a functional state when the received voltage signals from the peripheral voltage sensor and the supply voltage sensor comply with two thresholds, i.e., a threshold voltage amount difference and a threshold phase angle difference, a likelihood of 'false positives' can be reduced, in particular, in comparison to the case if only one threshold, such as a threshold voltage amount difference (alone), would be considered. A false positive would consists in determining that the electric connection is in a functional state when the electric connection is in fact in a dysfunctional state, in particular in an interrupted state and/or a falsely wired state. Reliability of the result can thus be improved.

In particular, in electric circuitries in which a plurality of electric circuits is arranged in close proximity to each other, 'cross talk' between the currents in mutually adjacent circuits typically occurs, by electric induction and other effects. A voltage amount thus can be detectable in a circuit which differs from an amount of a supply voltage applied to that circuit, including cases in which a voltage is detected in the circuit when an (intended) electric connection between the circuit and a power supply line is dysfunctional, such as due to interruption or false wiring. In such cases, considering a phase angle difference when determining that the electric connection is in a functional state enables avoiding false positives which may otherwise result from a voltage present in the circuit due to false wiring to an unintended supply line or cross talk from an adjacent circuit. This is enabled, as the phases of the voltages in different circuits and/or different supply lines are, systematically or incidentally, unequal in many cases. The reliability of the result can thus be further improved.

Furthermore, by determining that the electric connection between the electric conductor and the supply line is in a dysfunctional state when the comparing of the voltage amount difference with the threshold voltage amount difference yields that the voltage amount difference exceeds the threshold voltage amount difference, a necessity to perform an additional evaluation of the phase angle difference between the voltages is avoidable in many real-life scenarios in which an electric connection is in a dysfunctional state, in particular in an interrupted state. By dispensing with a processing of phase angle information in such cases, an efficiency of the method is improved. The method thus facilitates, in particular, a fast and economic determining of a dysfunctional state of the electric connection in many cases, in terms of processing resources which are required for performing the method and of an available reaction time for (automatically) initiating one or more technical measures in response to the determined dysfunctional state.

Furthermore, in the aforesaid cases in which a dysfunctional state of the electric connection results from interruption of the electric connection and can be determined based (only) on the voltage amount difference, a difference between the supply voltage and the voltage in the electric conductor as indicated by the received voltage signals is typically large. This facilitates choosing a relatively large threshold voltage amount difference when implementing the method, without unduly affecting an efficiency of the method. By permitting a large threshold voltage amount difference, a likelihood of 'false negatives' can be reduced, in particular, in comparison to the case if a small voltage amount difference were used. A false negative would consist in determining that the electric connection is in a dysfunctional state when the electric connection is in fact in a functional state, in particular in a non-interrupted state and/or a correctly wired state. Choosing a relatively large threshold voltage amount difference, as facilitated by the method, reduces a likelihood that a variation in the voltage in the electric conductor, as may occur even during a normal operation of the electric system, will exceed the threshold voltage amount difference and thus lead to a false determining of a supposedly dysfunctional state of the electric connection. The reliability of the result, in terms of an avoidance of false negatives, can thus be further improved. Meanwhile, an increased likelihood of false positives which may result from a relatively large threshold voltage amount difference is avoidable by the method in many relevant scenarios by additionally considering in such cases a threshold phase angle difference, as set out above.

Furthermore, by facilitating the use of a relatively large threshold voltage amount difference, a precision tolerance concerning the voltage amount information contained in the peripheral voltage signal can be increased. This permits an implementation of the method with a wide range of types and qualities of peripheral voltage sensors and a wide range of conditions under which the peripheral voltage sensor is operated. Thus, improved cost efficiency and an extended range of possible applications of the method are enabled.

The method may further comprise, when the comparing of the phase angle difference with the threshold phase angle difference yields that the phase angle difference exceeds the threshold phase angle difference, determining, by means of the control unit, that the electric connection between the electric conductor and the supply line is in a dysfunctional state.

The method may further comprise outputting, by means of the control unit, a control signal indicative of the determined state of the electric connection between the electric conductor and the supply line. The control signal may be configured to control one or more technical devices in response to the determined state. The one or more technical devices may comprise a user interface, in particular a graphical and/or acoustic user interface, wherein the control signal may be configured to control the user interface such that information indicative of the determined state is output towards a user by means of the user interface. Additionally, or alternatively, the technical devices may comprise a controllable electric circuitry component, wherein the control signal may be configured to control the electric circuitry component such that an electric configuration of the electric circuitry is adapted by means of the controllable electric circuitry component depending on the determined state.

The threshold voltage amount difference may be larger than 30%, preferably larger than 50%, more preferably larger than 70%, of the voltage amount of the voltage of the supply line. Additionally, or alternatively, the threshold voltage amount difference may be smaller than 95%, preferably smaller than 90%, more preferably smaller than 85%, of the voltage amount of the voltage of the supply line.

The threshold voltage amount difference may be variable. The method may further comprise setting the threshold voltage amount difference based on the determined voltage amount of the voltage of the supply line.

The supply line may be a multi-phase supply line having a plurality of electric phases. The electric conductor may be configured to be connected to an electric phase of the plurality of electric phases, and the supply voltage signal may be indicative of a voltage of the electric phase of the supply line which the electric conductor is configured to be connected to.

The plurality of electric conductors may be arranged adjacent to each other in the electric circuitry. Pairwise adjacent ones of the plurality of electric conductors may be configured to be electrically connected to different electric phases of the multi-phase supply line.

The threshold phase angle difference may be equal to or larger than 50% of a phase angle difference between the electric phase which the electric conductor is configured to be connected to and at least one other electric phase of the multi-phase supply line which at least one other of the plurality of electric conductors, which is arranged adjacent the electric conductor, is configured to be connected to.

The peripheral voltage sensor may be arranged at the electric conductor and may be configured to detect an electric field which is produced by an electric potential of the electric conductor in a proximity of the electric conductor. Additionally, or alternatively, the supply voltage sensor may be arranged at the supply line and may be configured to detect a voltage applied to the supply line.

According to another aspect, a computer program product is provided. The computer program product comprises portions of program code which, when executed by a processor of a control unit for an electric monitoring system, configure the control unit to perform the method as provided herein.

According to another aspect, a control unit for an electric monitoring system is provided. The control unit comprises a processor, and a data storage device operatively coupled to the processor. The data storage device stores portions of program code which, when executed by the processor, configure the control unit to perform the method as provided herein.

According to another aspect, an electric monitoring system is provided. The electric monitoring system comprises a control unit as provided herein, at least one peripheral voltage sensor operatively coupled to the control unit, the peripheral voltage sensor configured to provide a peripheral voltage signal indicative of a voltage in an electric conductor of a plurality of electric conductors of an electric circuitry, and at least one supply voltage sensor operatively coupled to the control unit, the supply voltage sensor configured to provide a supply voltage signal indicative of a voltage of a supply line which the electric conductor is configured to be connected to in the electric circuitry.

The electric monitoring system may comprise a plurality of peripheral voltage sensors. Each of the peripheral voltage sensors may be configured to provide a peripheral voltage signal indicative of a voltage in a respective different one of the plurality of electric conductors of the electric circuitry. The plurality of peripheral voltage sensors may be arranged in a sensor module of the electric monitoring system. The sensor module may be operatively coupled to the control unit and may be configured to be positioned on the plurality of electric conductors.

The supply line may be a multi-phase supply line having a plurality of electric phases. The plurality of electric conductors may be arranged adjacent to each other in the electrical circuitry. Pairwise adjacent ones of the plurality of electric conductors may be configured to be electrically connected to different ones of the plurality of electric phases of the supply line. The electric monitoring system may comprise a plurality of supply voltage sensors. Each of the supply voltage sensors may be configured to provide a supply voltage signal indicative of a voltage of a respective different one of the plurality of electric phases of the supply line.

The control unit and the at least one supply voltage sensor may be parts of a base module of the electric monitoring system. The at least one peripheral voltage sensor may be operatively coupled to the base module.

### Brief Description of the Drawings

Further details, effects and advantages of the disclosure will be apparent from the drawings and the detailed description. There is shown in:
- Fig. 1: an electric monitoring system according to an example, and
- Fig. 2: a method of determining a functionality state of an electric connection between one or more of a plurality of electric conductors and a power supply in an electric circuitry, according to an example.

### Detailed Description of the Disclosure

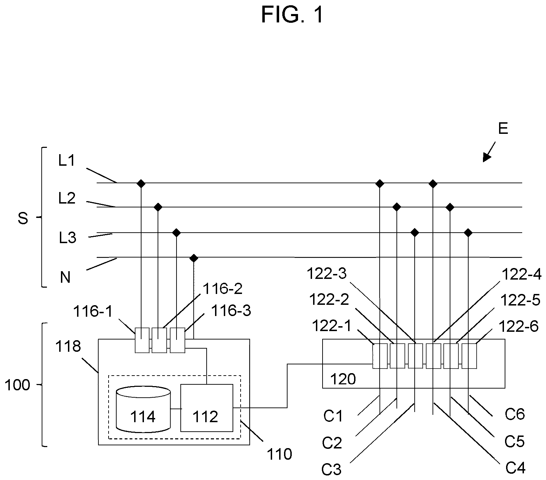

Fig. 1 shows schematically and exemplarily an electric monitoring system 100 which is connected to an electric circuitry E. The electric circuitry E comprises a supply line S which provides electric power to a plurality of electric circuits which are connected to the supply line S by a plurality of electric conductors C1 - C6.

In the shown example, the supply line S comprises a plurality of electric phases L1, L2, L3, conducted by different wires, and a neutral potential N. In some examples, the supply line S is configured to provide alternating current, and the electric phases L1 - L3 are shifted relative to each other with respect to a phase angle of the alternating voltage in each of the electric phases L1 - L3. For example, the angle difference corresponds to 360° divided by the number of electric phases L1 - L3 contained in the supply line S. In the example of Fig. 1, this corresponds to a phase angle difference of 120° between each pair of different phases.

Furthermore, in the shown example, the plurality of electric conductors C1 - C6 are connected to different ones of the electric phases L1 - L2, respectively. In the example shown in Fig. 1, pairwise adjacent ones of the electric conductors C1 - C6 are connected to respectively different ones of the electric phases L1 - L3.

The electric monitoring system 100 comprises a control unit 110. The control unit 110 comprises a processor 112 and a data storage device 114 operationally coupled to the processor 112. The data storage device 114 stores portions of program code which are accessible and executable by means of the data processor 112 and, when executed by means of the processor 112, configure the control unit 110 to perform any of the operations described herein.

The electric monitoring system 100 further comprises a plurality of peripheral voltage sensors 122-1 - 122-6, which are operationally coupled to the control unit 110. In the shown example, each of the plurality of peripheral voltage sensors 122-1 - 122-6 is associated with a different one of the electric conductors C1 - C6 and is configured to provide a peripheral voltage signal to the control unit 110. The peripheral voltage signal is indicative of a voltage in the respective electric conductor C1 - C6.

The electric monitoring system 100 further comprises a plurality of supply voltage sensors 116-1 - 116-3, which are operationally coupled to the control unit 110. In the shown example, each of the plurality of supply voltage sensors 116-1 - 116-3 is associated with a different one of the electric phases L1 - L3 and is configured to provide a supply voltage signal indicative of a voltage of the respective electric phase L1 - L3.

In the shown example, the control unit 110 and the supply voltage sensors 116-1 - 116-2 are parts of a base module 118 of the electric monitoring system 100. In this example, the control unit 110 is connected to the supply line S through the supply voltage sensors 116-1 - 116-2 to obtain electric power for the control unit 110 from the supply line S. In other examples, powering of the control unit 110 is provided separately from the supply line S.

Furthermore, in the shown example, the plurality of peripheral voltage sensors 122-1 - 122-6 are arranged in a sensor module 120 of the electric monitoring system 100. In the example, the sensor module 120 is operatively coupled to the base module 110 and is configured to be positioned on the plurality of electric conductors C1 - C6.

During an operation, the control unit 110 receives supply voltage signals from each of the supply voltage sensors 116-1 - 116-2 and peripheral voltage signals from each of the peripheral voltage sensors 122-1 - 122-6.

When an electric connection between any one of the plurality of electric conductors C1 - C6 and the associated electric phase L1 - L3 of the supply line S is functional, a voltage in the electric conductor C1 - C6 essentially corresponds to a voltage in the associated electric phase L1 - L3. In particular, in such case, a voltage amount in the electric phase L1 - L3 normally differs from a voltage amount in the associated electric conductor C1 - C6 only within a limited range, as may be caused during normal operation of the electric system to which the electric circuitry E pertains. This includes voltage variations in the electric conductors C1 - C6 caused by crosstalk between different ones of the electric conductors C1 - C6. Furthermore, in such case, a phase angle of the voltage in the electric phase L1 - L3 differs from a phase angle of the voltage in the associated electric conductor C1 - C6 only within a limited range as caused by normal operation of the electric system to which the electric circuitry E pertains, including phase angle variations in the electric conductors C1 - C6 caused by crosstalk between the electric conductors C1 - C6.

As described in more detail below, the electric monitoring system 100 is configured to process the voltage signals received from the supply voltage sensors 116-1 - 116-3 and the peripheral voltage sensors 122-1 - 122-6 with respect to both a voltage amount and a phase angle to determine a functionality state of the electric connection of any of the electric conductors C1 - C6 to the supply line S.

In the following, for convenience, functionalities of the electric monitoring system 100 will be described exemplarily with reference to the electric conductor C2 and an electric connection between the electric conductor C2 and the supply line S. However, the following description applies analogously to any other of the conductors C1 - C6 and their respective electric connections to the supply line S. Moreover, it will be understood that in some examples the following operations can be performed by means of the control unit 110 simultaneously for any of the electric conductors C1 - C6.

The control unit 110 uses the peripheral voltage signal received from the peripheral voltage sensor 122-2 and the supply voltage signal received from the supply voltage sensor 116-2 to determine a voltage amount difference ΔA between a voltage amount of the voltage in the electric conductor C2 and a voltage amount of the voltage in the electric phase L2 of the supply line S. In some examples, the control unit 110 is configured to determine the voltage amount difference ΔA continuously. In other examples the control unit 110 is configured to determine the voltage amount difference ΔA at predefined intervals, such as in intervals of 0.1 seconds, etc.

The control unit 110 compares the voltage amount difference ΔA with a threshold voltage amount difference T1.

In some examples, the control unit 110 dynamically sets the threshold voltage amount difference T1 based on the detected voltage amount in the electric phase L2. In this way, a relative sensitivity for determining a dysfunctional state of the connection between the electric conductor C2 and the electric phase L2 based on the voltage amount difference ΔA can be adapted for varying supply voltages. In other examples, the threshold voltage amount difference T1 is predefined and stored in the data storage device 114.

In some examples, the threshold voltage amount difference T1 is larger than 30%, such as larger than 50%, such as larger than 70%, of the voltage amount of the voltage of the electric phase L2. Additionally, or alternatively, in some examples, the threshold voltage amount difference T1 is smaller than 95%, such as smaller than 90%, such as smaller than 85%, of the voltage amount of the voltage of the electric phase L2.

In some examples in which the control unit 110 sets the threshold voltage amount difference T1 dynamically, the control unit is configured to set the threshold voltage amount difference T1 based on the voltage amount in the electric phase L2 in accordance with any of the aforesaid limits.

In some examples in which the threshold voltage amount difference T1 is predefined, the stored threshold voltage amount difference T1 has been selected in accordance with any of the aforesaid limits relative to a standard voltage amount at which the electric phase L2 is configured and/or intended to be operated.

When the comparison yields that the voltage amount difference ΔA exceeds the threshold voltage amount difference T1, the control unit 110 determines that the electric connection between the electric conductor C2 and the electric phase L2 is in a dysfunctional state.

A dysfunctional state includes, for example, a breaking of the electric connection, false wiring of the electric conductor C2 in the electric circuitry E during set up, tripping of a power switch (not shown) which is arranged on the electric conductor C2 upstream from the peripheral voltage sensor 122-2, or the like. Such cases result in a significant drop of a voltage amount in the electric conductor C2 relative to the normal operation and, hence, will be detectable by a comparison of the voltage amount difference ΔA with a suitably chosen threshold voltage amount difference T1.

Otherwise, when the comparison yields that the voltage amount difference ΔA does not exceed the threshold voltage amount difference T1, the control unit 110 uses the received peripheral voltage signal and the received supply voltage signal to determine a phase angle difference ΔP between a phase angle of the voltage in the electric conductor C2 and a phase angle of the voltage of the electric phase L2.

The control unit 110 compares the phase angle difference ΔP with a threshold phase angle difference T2.

In some examples, the threshold phase angle difference T2 is predefined and stored in the data storage device 114. In other examples the threshold phase angle difference T2 is variable and is set by means of the control unit 110 dynamically, for example, based on phase angle information contained in the supply voltage signals obtained about each of the electric phases L1 - L3.

In some examples, the threshold phase angle difference T2 equals 50% of a phase angle difference between the electric phase L2, to which the electric conductor C2 is configured to be connected, and at least one of the electric phases L1, L3 of the supply line S, to which other ones, for example adjacent ones, of the electric conductors C1, C3 - C6 are connected. When the threshold phase angle difference T2 is chosen in this way, a voltage in the electric conductor C2 having a phase angle that exceeds the threshold phase angle difference T2 relative to the phase angle of the voltage in the electric phase L2 likely results from crosstalk from a corresponding adjacent electric conductor C1, C3 of the electric conductor C2 rather than from phase angle variations that may occur during normal operation of the electric circuitry E. This is because very large phase angle variations occur rarely in a functional state, and one of the adjacent conductors C1, C3 is fed by the supply line S with a voltage having a phase angle that corresponds to a smaller phase angle difference relative to the phase angle detected in the electric conductor C2, thus rendering crosstalk the more likely cause.

Conversely, for the same reason, when the phase angle difference ΔP is smaller than the threshold phase angle difference T2, the phase angle difference ΔP results more likely from variations that may occur during normal operation of the electric circuitry E than from crosstalk.

Accordingly, when the comparing of the phase angle difference ΔP with the threshold phase angle difference T2 yields that the phase angle difference ΔP does not exceed the threshold phase angle difference T2, the control unit 110 determines that the electric connection between the electric conductor C2 and the electric phase L2 is in a functional state.

In some examples of the electric monitoring system 100, the control unit 110 determines that the electric connection between the electric conductor C2 and the electric phase L2 is in a dysfunctional state, when the comparing of the phase angle difference ΔP with the threshold phase angle difference T2 yields that the phase angle difference ΔP exceeds the threshold phase angle difference T2.

In some examples of the electric monitoring system 100, the control unit 110 outputs, via an output interface of the control unit 110 (not shown), a control signal indicative of the determined state of the electric connection. The control signal is in some examples configured to control a user interface for informing a user, for example, an operator, of the electric circuitry E of the determined state of the electric connection. Moreover, in some examples, the control signal is configured to control a controllable electric component of the electric circuitry E for initiating a response measure according to the determined functional or dysfunctional state of the electric connection.

Each of the peripheral voltage sensors 122-1 - 122-6 is in some examples suited for detecting an electric field that is produced by an electric potential of the respective electric conductor C1 - C6 in a proximity of the electric conductor C1 - C6.

Each of the supply voltage sensors 116-1 - 116-3 is in some examples configured to detect a voltage applied to the respective electric phase L1 - L3 and passing through the corresponding supply voltage sensor 116-1 - 116-3, for example, for powering the control unit 110.

The electric monitoring system 100 has been described above in connection with a multiphase supply line having a plurality of electric phases and in connection with multiple electric circuits powered via the supply line by means of electric conductors which are coupled to the electric phases, wherein pairwise adjacent ones of the electric conductors are connected to different ones of the electric phases. However, it will be understood that some or all of the above-described effects and advantages are also achievable with other electric circuitry arrangements.

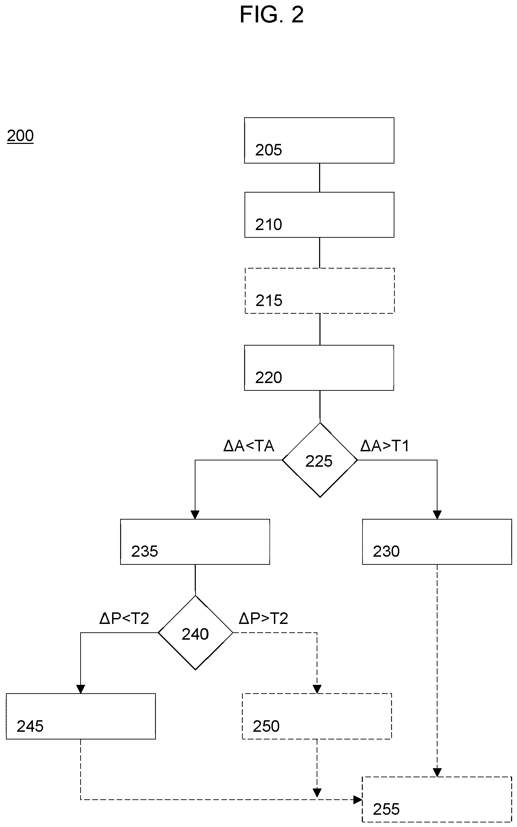

Fig. 2 shows a flow diagram of a method 200 for determining a functionality state of an electric connection between one or more of a plurality of electric conductors and a power supply in an electric circuitry. The method 200 is executable, for example, by means of the control unit 110 and in connection with an electric circuitry as described above in connection with Fig. 1.

The method 200 comprises receiving one or more peripheral voltage signals from one or more peripheral voltage sensors, step 205. The one or more peripheral voltage signals are indicative of a voltage in an electric conductor of the plurality of electric conductors of an electric circuitry. Moreover, the method 200 comprises receiving a supply voltage signal from one or more supply voltage sensors, step 210. The one or more supply voltage signals are indicative of a voltage of a supply line which the electric conductor is configured to be connected to in the electric circuitry.

The method 200 further comprises determining a voltage amount difference, such as voltage amount difference ΔA described above, between a voltage amount of the voltage in the electric conductor and a voltage amount of the voltage of the supply line, step 220. Determining the voltage amount difference is performed based on the received peripheral voltage signal and the received supply voltage signal. Moreover, the method 200 comprises comparing the voltage amount difference with a threshold voltage amount difference, such as threshold voltage amount difference T1 described above, step 225.

When the comparing of the voltage amount difference with the threshold voltage amount difference yields that the voltage amount difference exceeds the threshold voltage amount difference, 'ΔA>T1'-branch in Fig. 2, it is determined that an electric connection between the electric conductor and the supply line is in a dysfunctional state, step 230.

Otherwise, when the comparing of the voltage amount difference with the threshold voltage amount difference yields that the voltage amount difference does not exceed the threshold voltage amount difference, the method continues along the 'ΔA<T1'-branch in Fig. 2, as described below.

Based on the received peripheral voltage signal and the received supply voltage signal, a phase angle difference is determined between a phase angle of the voltage in the electric conductor and a phase angle of the voltage of the supply line, step 235. The phase angle difference is compared with a threshold phase angle difference, such as threshold phase angle difference T2 described above, step 240.

When the comparing of the phase angle difference with the threshold phase angle difference yields that the phase angle difference does not exceed the threshold phase angle difference, 'ΔP<T2'-branch in Fig. 2, an electric connection between the electric conductor and the supply line is determined to be in a functional state, step 245.

In some examples, as indicated in Fig. 2 by dashed lines, the method 200 further comprises setting the threshold voltage amount difference based on the determined voltage amount of the voltage of the supply line, step 215. This enables in some examples a dynamic adaption of the threshold voltage amount difference in accordance with a variable amount of the supply voltage. In other examples, the threshold voltage amount difference is predefined, for example, as a stored parameter in a data storage device of a control unit performing the method 200.

In some examples, as indicated in Fig. 2 by dashed lines, the method 200 further comprises determining that the electric connection between the electric conductor and the supply line is in a dysfunctional state when the comparing of the phase angle difference with the threshold phase angle difference at step 240 yields that the phase angle difference exceeds the threshold phase angle difference, 'ΔT>T2'-branch and step 250.

In some examples, as indicated in Fig. 2 by dashed lines, the method 200 further comprises outputting a control signal indicative of a determined state among one or more of the states of the electronic connection between the electric conductor and the supply line that may be determined in the respective example of the method 200, step 255. For example, a control signal indicative of the determined state is output in some implementations of the method 200 when a dysfunctional state of the electric connection has been detected in step 230, or in step 250, whereas a control signal is not output in some or all of these examples when it has been determined that the electric connection is in a functional state at step 245. In other examples of the method 200, a control signal indicative of the determined state is output in other or additional cases depending on a determined state of the electric connection.

## Claims

1. Method (200) of determining a functionality state of an electric connection between one or more of a plurality of electric conductors (C1 - C6) and a power supply in an electric circuitry (E), wherein the method (200) comprises:
- receiving (205), by means of a control unit (110) of an electric monitoring system (100), at least one peripheral voltage signal from at least one peripheral voltage sensor (122-1 - 122-6), the at least one peripheral voltage signal indicative of a voltage in an electric conductor (C1 - C6) of a plurality of electric conductors (C1 - C6) of an electric circuitry (E);
- receiving (210), by means of the control unit (110), a supply voltage signal from at least one supply voltage sensor (116-1 - 116-3), the supply voltage signal indicative of a voltage of a supply line (S) which the electric conductor (C1 - C6) is configured to be connected to in the electric circuitry (E);
- determining (220), by means of the control unit (110) and based on the received peripheral voltage signal and the received supply voltage signal, a voltage amount difference (ΔA) between a voltage amount of the voltage in the electric conductor (C1 - C6) and a voltage amount of the voltage of the supply line (S);
- comparing (225), by means of the control unit (110), the voltage amount difference (ΔA) with a threshold voltage amount difference (T1);
- when the comparing (225) of the voltage amount difference (ΔA) with the threshold voltage amount difference (T1) yields that the voltage amount difference (ΔA) exceeds the threshold voltage amount difference (T1), determining (230), by means of the control unit (110), that an electric connection between the electric conductor (C1 - C6) and the supply line (S) is in a dysfunctional state, and
- when the comparing (225) of the voltage amount difference (ΔA) with the threshold voltage amount difference (T1) yields that the voltage amount difference (ΔA) does not exceed the threshold voltage amount difference (T1):
∘ determining (235), by means of the control unit (110) and based on the received peripheral voltage signal and the received supply voltage signal, a phase angle difference (ΔP) between a phase angle of the voltage in the electric conductor (C1 - C6) and a phase angle of the voltage of the supply line (S);
∘ comparing (240), by means of the control unit (110), the phase angle difference (ΔP) with a threshold phase angle difference (T2), and
∘ when the comparing (240) of the phase angle difference (ΔP) with the threshold phase angle difference (T2) yields that the phase angle difference (ΔP) does not exceed the threshold phase angle difference (T2), determining (245), by means of the control unit (110), that an electric connection between the electric conductor (C1 - C6) and the supply line (S) is in a functional state.

2. Method according to claim 1, further comprising: when the comparing (240) of the phase angle difference (ΔP) with the threshold phase angle difference (T2) yields that the phase angle difference (ΔP) exceeds the threshold phase angle difference (T2), determining (250), by means of the control unit (110), that the electric connection between the electric conductor (C1 - C6) and the supply line (S) is in a dysfunctional state.

3. Method according to claim 1 or claim 2, further comprising: outputting (255), by means of the control unit (110), a control signal indicative of the determined state of the electric connection between the electric conductor (C1 - C6) and the supply line (S).

4. Method according to any one of the preceding claims, wherein the threshold voltage amount difference (T1) is larger than 30%, preferably larger than 50%, more preferably larger than 70%, of the voltage amount of the voltage of the supply line (S), and/or wherein the threshold voltage amount difference (T1) is smaller than 95%, preferably smaller than 90%, more preferably smaller than 85%, of the voltage amount of the voltage of the supply line (S).

5. Method according to any one of the preceding claims, wherein the threshold voltage amount difference (T1) is variable, and wherein the method (200) further comprises setting (215) the threshold voltage amount difference (T1) based on the determined voltage amount of the voltage of the supply line (S).

6. Method according to any one of the preceding claims, wherein the supply line (S) is a multi-phase supply line having a plurality of electric phases (L1 - L3), the electric conductor (C1 - C6) is configured to be connected to an electric phase (L1 - L3) of the plurality of electric phases, and the supply voltage signal is indicative of a voltage of the electric phase (L1 - L3) of the supply line (S) which the electric conductor (C1 - C6) is configured to be connected to.

7. Method according to claim 6, wherein the plurality of electric conductors (C1 - C6) are arranged adjacent each other in the electric circuitry (E), and pairwise adjacent ones of the plurality of electric conductors (C1 - C6) are configured to be electrically connected to different electric phases (L1 - L3) of the multi-phase supply line (S).

8. Method according to claim 7, wherein the threshold phase angle difference (T2) is equal to or larger than 50% of a phase angle difference between the electric phase (L1 - L3) which the electric conductor (C1 - C6) is configured to be connected to and at least one other electric phase (L1 - L3) of the multi-phase supply line (S) which at least one other of the plurality of electric conductors (C1 - C6), which is arranged adjacent the electric conductor (C1 - C6), is configured to be connected to.

9. Method according to any one of the preceding claims, wherein the peripheral voltage sensor (122-1 - 122-6) is arranged at the electric conductor (C1 - C6) and is configured to detect an electric field which is produced by an electric potential of the electric conductor (C1 - C6) in a proximity of the electric conductor (C1 - C6), and/or wherein the supply voltage sensor (116-1 - 116-3) is arranged at the supply line (S) and is configured to detect a voltage applied to the supply line (S).

10. Computer program product comprising portions of program code which, when executed by a processor of a control unit for an electric monitoring system, configure the control unit to perform the method according to any one of the preceding claims.

11. Control unit (110) for an electric monitoring system (100), the control unit (110) comprising:
- a processor (112), and
- a data storage device (114) operatively coupled to the processor (112) and storing portions of program code which, when executed by the processor (112), configure the control unit (110) to perform the method according to any one of claims 1 to 9.

12. Electric monitoring system (100) comprising:
- a control unit (110) according to claim 11,
- at least one peripheral voltage sensor (122-1 - 122-6) operatively coupled to the control unit (110), the peripheral voltage sensor (122-1 - 122-6) configured to provide a peripheral voltage signal indicative of a voltage in an electric conductor (C1 - C6) of a plurality of electric conductors (C1 - C6) of an electric circuitry (E), and
- at least one supply voltage sensor (116-1 - 116-3) operatively coupled to the control unit (110), the supply voltage sensor (116-1 - 116-3) configured to provide a supply voltage signal indicative of a voltage of a supply line (S) which the electric conductor (C1 - C6) is configured to be connected to in the electric circuitry (E).

13. Electric monitoring system according to claim 12, wherein the electric monitoring system (100) comprises a plurality of peripheral voltage sensors (122-1 - 122-6), each of the peripheral voltage sensors (122-1 - 122-6) configured to provide a peripheral voltage signal indicative of a voltage in a respective different one of the plurality of electric conductors (C1 - C6) of the electric circuitry (E),
wherein, preferably, the plurality of peripheral voltage sensors (122-1 - 122-6) are arranged in a sensor module (120) of the electric monitoring system (100), the sensor module (120) operatively coupled to the control unit (110) and configured to be positioned on the plurality of electric conductors (C1 - C6).

14. Electric monitoring system according to claim 12 or claim 13, wherein:
- the supply line (S) is a multi-phase supply line having a plurality of electric phases (L1, L2, L3);
- the plurality of electric conductors (C1 - C6) are arranged adjacent each other in the electrical circuitry (E);
- pairwise adjacent ones of the plurality of electric conductors (C1 - C6) are configured to be electrically connected to different ones of the plurality of electric phases (L1, L2, L3) of the supply line (S), and
- the electric monitoring system (100) comprises a plurality of supply voltage sensors (116-1 - 116-3), each of the supply voltage sensors (116-1 - 116-3) configured to provide a supply voltage signal indicative of a voltage of a respective different one of the plurality of electric phases (L1, L2, L3) of the supply line (S).

15. Electric monitoring system according to any one of claims 12 to 14, wherein the control unit (110) and the at least one supply voltage sensor (116-1 - 116-3) are parts of a base module (118) of the electric monitoring system (100), wherein the at least one peripheral voltage sensor (122-1 - 122-6) is operatively coupled to the base module (118).

## Amended claims

### Amended claims in accordance with Rule 137(2) EPC.

1. Method (200) of determining a functionality state of an electric connection between one or more of a plurality of electric conductors (C1 - C6) and a power supply in an electric circuitry (E), wherein the method (200) comprises:
- receiving (205), by means of a control unit (110) of an electric monitoring system (100), at least one peripheral voltage signal from at least one peripheral voltage sensor (122-1
- 122-6), the at least one peripheral voltage signal indicative of a voltage in an electric conductor (C1 - C6) of a plurality of electric conductors (C1 - C6) of an electric circuitry (E);
- receiving (210), by means of the control unit (110), a supply voltage signal from at least one supply voltage sensor (116-1 - 116-3), the supply voltage signal indicative of a voltage of a supply line (S) which the electric conductor (C1 - C6) is configured to be connected to in the electric circuitry (E);
- determining (220), by means of the control unit (110) and based on the received peripheral voltage signal and the received supply voltage signal, a voltage amount difference (ΔA) between a voltage amount of the voltage in the electric conductor (C1 - C6) and a voltage amount of the voltage of the supply line (S);
- comparing (225), by means of the control unit (110), the voltage amount difference (ΔA) with a threshold voltage amount difference (T1);
- when the comparing (225) of the voltage amount difference (ΔA) with the threshold voltage amount difference (T1) yields that the voltage amount difference (ΔA) exceeds the threshold voltage amount difference (T1), determining (230), by means of the control unit (110), that an electric connection between the electric conductor (C1 - C6) and the supply line (S) is in a dysfunctional state, and
- when the comparing (225) of the voltage amount difference (ΔA) with the threshold voltage amount difference (T1) yields that the voltage amount difference (ΔA) does not exceed the threshold voltage amount difference (T1):
o determining (235), by means of the control unit (110) and based on the received peripheral voltage signal and the received supply voltage signal, a phase angle difference (ΔP) between a phase angle of the voltage in the electric conductor (C1 - C6) and a phase angle of the voltage of the supply line (S);
∘ comparing (240), by means of the control unit (110), the phase angle difference (ΔP) with a threshold phase angle difference (T2), and
∘ when the comparing (240) of the phase angle difference (ΔP) with the threshold phase angle difference (T2) yields that the phase angle difference (ΔP) does not exceed the threshold phase angle difference (T2), determining (245), by means of the control unit (110), that an electric connection between the electric conductor (C1 - C6) and the supply line (S) is in a functional state.

2. Method according to claim 1, further comprising: when the comparing (240) of the phase angle difference (ΔP) with the threshold phase angle difference (T2) yields that the phase angle difference (ΔP) exceeds the threshold phase angle difference (T2), determining (250), by means of the control unit (110), that the electric connection between the electric conductor (C1 - C6) and the supply line (S) is in a dysfunctional state.

3. Method according to claim 1 or claim 2, further comprising: outputting (255), by means of the control unit (110), a control signal indicative of the determined state of the electric connection between the electric conductor (C1 - C6) and the supply line (S).

4. Method according to any one of the preceding claims, wherein the threshold voltage amount difference (T1) is larger than 30%, preferably larger than 50%, more preferably larger than 70%, of the voltage amount of the voltage of the supply line (S), and/or wherein the threshold voltage amount difference (T1) is smaller than 95%, preferably smaller than 90%, more preferably smaller than 85%, of the voltage amount of the voltage of the supply line (S).

5. Method according to any one of the preceding claims, wherein the threshold voltage amount difference (T1) is variable, and wherein the method (200) further comprises setting (215) the threshold voltage amount difference (T1) based on the determined voltage amount of the voltage of the supply line (S).

6. Method according to any one of the preceding claims, wherein the supply line (S) is a multi-phase supply line having a plurality of electric phases (L1 - L3), the electric conductor (C1 - C6) is configured to be connected to an electric phase (L1 - L3) of the plurality of electric phases, and the supply voltage signal is indicative of a voltage of the electric phase (L1 - L3) of the supply line (S) which the electric conductor (C1 - C6) is configured to be connected to.

7. Method according to claim 6, wherein the plurality of electric conductors (C1 - C6) are arranged adjacent each other in the electric circuitry (E), and pairwise adjacent ones of the plurality of electric conductors (C1 - C6) are configured to be electrically connected to different electric phases (L1 - L3) of the multi-phase supply line (S).

8. Method according to claim 7, wherein the threshold phase angle difference (T2) is equal to or larger than 50% of a phase angle difference between the electric phase (L1 - L3) which the electric conductor (C1 - C6) is configured to be connected to and at least one other electric phase (L1 - L3) of the multi-phase supply line (S) which at least one other of the plurality of electric conductors (C1 - C6), which is arranged adjacent the electric conductor (C1 - C6), is configured to be connected to.

9. Method according to any one of the preceding claims, wherein the peripheral voltage sensor (122-1 - 122-6) is arranged at the electric conductor (C1 - C6) and is configured to detect an electric field which is produced by an electric potential of the electric conductor (C1 - C6) in a proximity of the electric conductor (C1 - C6), and/or wherein the supply voltage sensor (116-1 - 116-3) is arranged at the supply line (S) and is configured to detect a voltage applied to the supply line (S).

10. Control unit (110) for an electric monitoring system (100), the control unit (110) comprising:
- a processor (112), and
- a data storage device (114) operatively coupled to the processor (112) and storing portions of program code which, when executed by the processor (112), configure the control unit (110) to perform the method according to any one of claims 1 to 9.

11. Electric monitoring system (100) comprising:
- a control unit (110) according to claim 10,
- at least one peripheral voltage sensor (122-1 - 122-6) operatively coupled to the control unit (110), the peripheral voltage sensor (122-1 - 122-6) configured to provide a peripheral voltage signal indicative of a voltage in an electric conductor (C1 - C6) of a plurality of electric conductors (C1 - C6) of an electric circuitry (E), and
- at least one supply voltage sensor (116-1 - 116-3) operatively coupled to the control unit (110), the supply voltage sensor (116-1 - 116-3) configured to provide a supply voltage signal indicative of a voltage of a supply line (S) which the electric conductor (C1 - C6) is configured to be connected to in the electric circuitry (E).

12. Electric monitoring system according to claim 11, wherein the electric monitoring system (100) comprises a plurality of peripheral voltage sensors (122-1 - 122-6), each of the peripheral voltage sensors (122-1 - 122-6) configured to provide a peripheral voltage signal indicative of a voltage in a respective different one of the plurality of electric conductors (C1 - C6) of the electric circuitry (E),
wherein, preferably, the plurality of peripheral voltage sensors (122-1 - 122-6) are arranged in a sensor module (120) of the electric monitoring system (100), the sensor module (120) operatively coupled to the control unit (110) and configured to be positioned on the plurality of electric conductors (C1 - C6).

13. Electric monitoring system according to claim 11 or claim 12, wherein:
- the supply line (S) is a multi-phase supply line having a plurality of electric phases (L1, L2, L3);
- the plurality of electric conductors (C1 - C6) are arranged adjacent each other in the electrical circuitry (E);
- pairwise adjacent ones of the plurality of electric conductors (C1 - C6) are configured to be electrically connected to different ones of the plurality of electric phases (L1, L2, L3) of the supply line (S), and
- the electric monitoring system (100) comprises a plurality of supply voltage sensors (116-1 - 116-3), each of the supply voltage sensors (116-1 - 116-3) configured to provide a supply voltage signal indicative of a voltage of a respective different one of the plurality of electric phases (L1, L2, L3) of the supply line (S).

14. Electric monitoring system according to any one of claims 11 to 13, wherein the control unit (110) and the at least one supply voltage sensor (116-1 - 116-3) are parts of a base module (118) of the electric monitoring system (100), wherein the at least one peripheral voltage sensor (122-1 - 122-6) is operatively coupled to the base module (118).

15. Computer program product comprising portions of program code which, when executed by a processor of a control unit of an electric monitoring system according to one of claims 11 to 14, configure the control unit to perform the method according to any one of claims 1 to 9.
